# EUROPEAN PATENT APPLICATION

(11) **EP 2 530 710 A2**
(43) Date of publication of application: **05.12.2012**
(21) Application number: 12169576.1
(22) Date of filing: 25.05.2012
(51) Int. Cl.: H01L 23/49, H01L 21/60

(54) **Bonding wire, connection structure, semiconductor device and manufacturing method of same**

(30) Priority: 03.06.2011 JP 2011125556
(71) Applicant: Nippon Piston Ring Co., Ltd., Saitama-shi, Saitama 338-8503 (JP); Ibaraki University, Ibaraki 310-8512 (JP)
(72) Inventor: FUJII, Yoshitaka, Saitama City, Saitama 338-8503 (JP); ONUKI, Jin, Hitachi-shi,, Ibaraki 316-8511, (JP)
(74) Representative: TBK

(57) **Abstract**

The generation and propagation of cracks in a connection to a connected member is prevented. A semiconductor device 10 is provided with a connection structure 15 between a bonding wire 17 consisting of an aluminum alloy which contains at least magnesium and silicon and in which a total of contents of the magnesium and the silicon is not less than 0.03 wt% but not more than 1.0 wt% and a silicon chip 16 to which this bonding wire 17 is connected. An aluminum-silicon film 16a is formed on the surface of the silicon chip 16. This connection structure 15 has a compound 18 containingmagnesium and silicon in a matrix layer 17a constituting the bonding wire 17, in a fine grain layer 17b of the aluminum alloy formed between the matrix layer 17a and the aluminum-silicon film 16a, and at an interface between the matrix layer 17a and the fine grain layer 17b.

## Description

### BACKGROUND OF THE INVENTION

### Field of the Invention

The present invention relates to a bonding wire and a connection structure suitable for a power semiconductor, a semiconductor device provided with these, and a manufacturing method thereof.

### Description of the Related Art

A Si device which is a kind of a semiconductor is used as a discrete element such as a diode, a transistor and a thyristor, and as an integrated circuit such as a microcomputer, a memory and a communication device.

In a microcomputer and a memory, a Si device works for computation and memorization. On the other hand, there is a Si device called a power semiconductor and is used in power control. Thanks to a power semiconductor, rectification, frequency conversion, boosting and back-boosting and the like are possible. For example, a power semiconductor is used in various uses, such as driving of a motor and charging of a battery. For the kinds of power semiconductors, there are a power MOSFET (metal-oxide-semiconductor field-effect transistor), an IGBT (insulated gate bipolar transistor), a power bipolar transistor, a thyristor and the like. Among these power semiconductors, an IGBT is widely used in the market because of a large device capacity and a large range of adaptable operating frequency, excellent cost performance and the like.

In many cases, an IGBT is industrially used as a module structure in which a plurality of silicon chips are connected in parallel. Although the amount of a current flowing in one silicon chip is on the order of 100 A maximum, it is possible to handle a large current by adopting a module structure. Such an IGBT is used in a power generator using wind force, sunlight and the like, an industrial robot, an inverter in an automobile or an electric train, and the like. In recent years, due to an increase in hybrid vehicles (HV) and electric vehicles, the frequency of uses in automobiles has increased.

For an IGBT used in an automobile, the temperature warranty standard has become severe. Although a 120°C warranty has hitherto been general, at present a 150°C warranty is general and it is expected that the temperature warranty will be severer in the future. However, in an automobile in which a plurality of parts are densely arranged in a narrow space, the downsizing of an IGBT is demanded and it has become difficult to satisfy the temperature warranty standard which becomes severe because of an increase in heating value due to downsizing (refer to Patent Document 1, for example).

### [Citation List]

### [Patent Literature]

[Patent Literature 1] Japanese Patent Laid-Open No. 2008-311383 (refer to paragraph [0003])

### SUMMARY OF THE INVENTION

Breakages of an IGBT due to heat generation are divided into those caused by the deterioration of solder connections between a copper plate functioning as a heat sink and a ceramic substrate on which silicon chips are placed and those caused by the deterioration of the silicon chips and bonding wire connections. The deterioration of the bonding wire connections is due to thermal stresses generated by the repetition of the heating and cooling cycle during operation of a power module, and this is the result of the propagation of cracks, which occur due to a difference in the coefficient of linear expansion between the bonding wire and the silicon chips, in the vicinity of an interface.

In an IGBT having a module structure in which a plurality of silicon chips are connected, in the case where wire breaking occurs due to the deterioration of a bonding wire in one place, the current flowing through the bonding wire flows to another bonding wire. In the other bonding wire, the heating value increases due to an increase in the flowing current and hence the deterioration proceeds at an accelerated pace and eventually wire breaking occurs in a chain reaction.

Therefore, in order to satisfy the temperature warranty standard which becomes severer, it is effective to prevent the generation and propagation of cracks in a connection between a bonding wire and a connected member, such as a silicon chip, and to improve the heat resistance cycle characteristics.

The present invention was made in order to solve the above-described problem, and the object of the invention is to provide a bonding wire which prevents the generation and propagation of cracks in a connection to a connected member, a connection structure of the bonding wire, a semiconductor device provided with these and a manufacturing method of the semiconductor device.

(1) The present invention provides a bonding wire characterized in consisting of an aluminum alloy which contains at least magnesium and silicon and in that a total of contents of the magnesium and the silicon is not less than 0.03 wt% but not more than 1.0 wt%.

According to the present invention, the generation of cracks is prevented by the solid-solution hardening by magnesium and silicon. Furthermore, by subjecting a bonding wire to aging treatment, a compound consisting of magnesium and silicon, for example, Mg₂Si (called magnesium silicide) precipitates within the bonding wire, and the precipitation hardening by this compound prevents the propagation of cracks even when the cracks are generated in a connection to a connected member.

(2) The present invention provides also the bonding wire in (1) above characterized in having a diameter of not less than 10 µm but not more than 500 µm.

(3) The present invention provides also the bonding wire in (1) or (2) above **characterized in that** with the amount of increase in maximum hardness from an initial hardness to a maximum hardness due to aging treatment as a standard, aging treatment is performed until an increase in hardness of not less than 40% of the amount of increase in the maximum hardness is obtained.

According to the above-described invention, because the hardness of the bonding wire has not reached a maximum hardness, in connecting the bonding wire to a connected member, it is possible to prevent the connected member from being damaged due to the hardness of the bonding wire. In a semiconductor device provided with this connection, the age-hardening of the bonding wire proceeds more due to the heat generation during use. As a result of this, a longer operating life of this connection is achieved.

(4) The present invention provides also the bond ing wire in any of (1) to (3) above **characterized in that** the hardness becomes not more than 45 Hmv.

(5) The present invention provides also the bonding wire in (4) above **characterized in that** the hardness becomes not more than 35 Hmv.

(6) The present invention provides also the bonding wire in any of (1) to (5) above **characterized in that** the aluminum alloy contains not less than 0.1 wt% but not more than 1.0 wt% of copper.

According to the above-described invention, hardness is improved further because of the precipitation of Al₂Cu particles and Al₂CuMg particles.

(7) The present invention provides also the bonding wire in any of (1) to (6) above **characterized in that** the aluminum alloy contains not less than 0.001 wt% but not more than 0.01 wt% of nickel.

According to the above-described invention, humidity resistance is improved.

(8) The present invention also provides a connection structure characterized in being a connection structure between the bonding wire in any of (1) to (7) above and a connected member to which the bonding wire is connected and which consists of an aluminum material, and in that a compound containing magnesium and silicon precipitates in a matrix layer constituting the bonding wire, in a fine grain layer of the aluminum alloy formed between the matrix layer and the connected member, and at an interface between the matrix layer and the fine grain layer.

According to the above-described invention, the generation of cracks is prevented by the solid-solution hardening and precipitation hardening by the magnesium and silicon contained in the bonding wire consisting of an aluminum alloy. Furthermore, thanks to the precipitation hardening by a compound, in the case where a crack is generated in a connection to a connected member, the propagation of the crack is prevented.

(9) The present invention also provides the connection structure in (8) above **characterized in that** the compound contains aluminum.

(10) The present invention also provides the connection structure in (8) or (9) above **characterized in that** the amount of precipitation of the compound is not less than 0.5% in terms of the area ratio of a section in the direction of the interface.

(11) The present invention also provides a semiconductor device characterized in having the connection structure in any of (8) to (10) above.

(12) The present invention also provides a method of manufacturing the semiconductor device according to (11) above **characterized in that** after the bonding wire is connected to the connected member, the bonding wire is subjected to aging treatment.

According to the bonding wire in any of (1) to (7) above, the connection structure in any of (8) to (10) above, the semiconductor device in (11) above, and the method of manufacturing the semiconductor device in (12) above, it is possible to prevent the generation and propagation of cracks in a connection to a connected member.

### BRIEF DESCRIPTION OF THE DRAWINGS

Figure 1 is an appearance perspective view of a semiconductor device of the present invention;

Figure 2 is a sectional view of the main part of the semiconductor device shown in Figure 1;

Figure 3 (A) is a sectional view of a connection structure provided in the semiconductor device shown in Figure 1; Figures 3 (B) and 3 (C) are pictures obtained by photographing sections at the interface between a matrix layer and a fine grain layer shown in Figure 3 (A);

Figure 4 is a graph showing the hardness of aluminum alloys, the addition amount on the abscissa and the hardness of the aluminum alloys on the ordinate;

Figures 5 (A) and 5 (B) are each graphs showing the transition of hardness by aging treatment, with treatment time on the abscissa and hardness on the ordinate;

Figures 6 (A) and 6 (B) are graphs showing the shear strength in the connection structure shown in Figures 3 (A) to 3 (C), with the heating and cooling cycle number on the abscissa and shearing strength on the ordinate;

Figures 7 (A) and 7 (B) are graphs showing the deterioration rate of shearing strength in the connection structure shown in Figures 3 (A) to 3 (C), with the heating and cooling cycle number on the abscissa and the deterioration rate of shearing strength on the ordinate;

Figure 8 is a graph showing the deterioration rate of shearing strength in the connection structure shown in Figures 3 (A) to 3 (C), with the addition amount of magnesium silicide on the abscissa and the deterioration rate of shearing strength on the ordinate;

Figure 9 is a graph showing the transition of tensile strength by aging treatment, with treatment time on the abscissa and tensile strength on the ordinate; and

Figures 10 (A) and 10 (B) are each graphs showing the hardness of an aluminum alloy, with the addition amount on the abscissa and the hardness of the aluminum alloy on the ordinate.

### DETAILED DESCRIPTION OF THE PREFERRED EMBODIMENTS

Referring to the drawings, a detailed description will be given below of a semiconductor device 10 of the present invention.

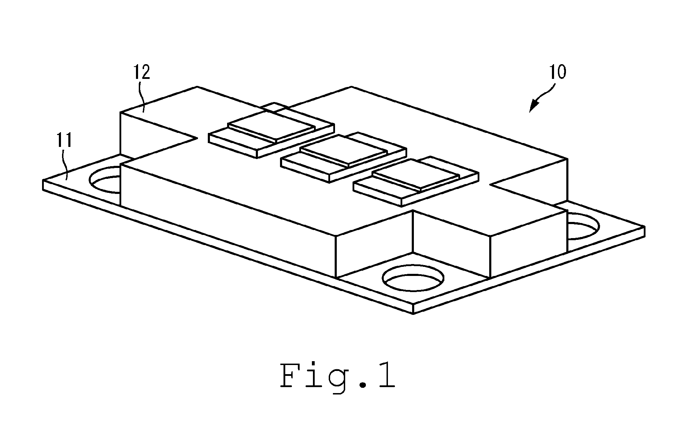

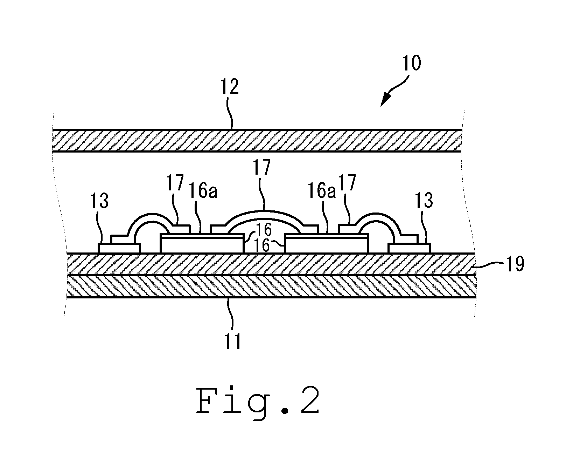

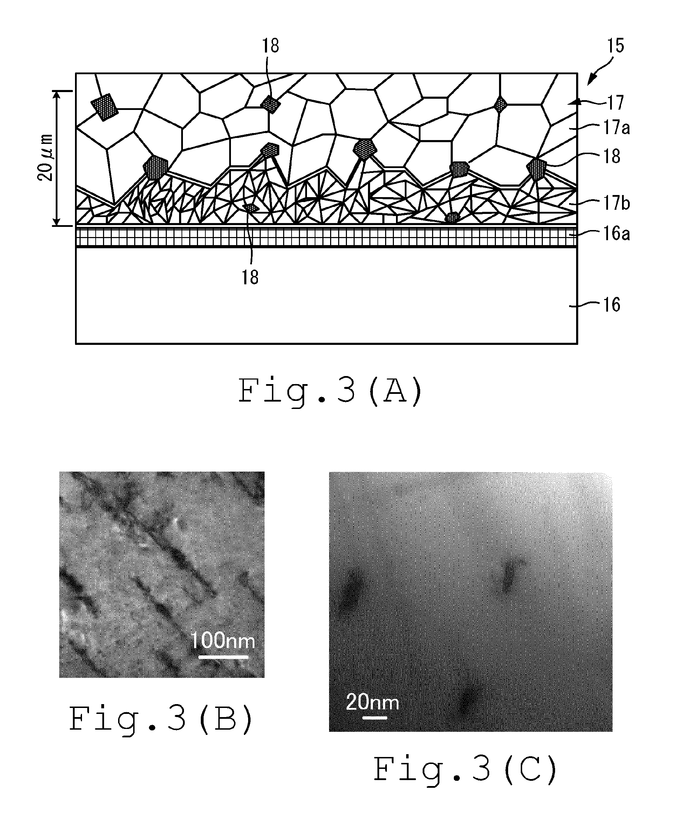

First, the configuration of the semiconductor device 10 will be described with the aid of Figure 1 to Figures 3 (A) to 3 (C). Figure 1 is an appearance perspective view of the semiconductor device 10. Figure 2 is a sectional view of the main part of the semiconductor device 10. Figure 3 (A) is a sectional view of a connection structure 15. Figure 3 (B) is a picture obtained by photographing a section at the interface between a matrix layer 17a and a fine grain layer 17b, showing the portion in which a compound 18 is formed as a rod-like precipitate. Figure 3 (C) is a picture obtained by photographing a section at the interface between the matrix layer 17a and the fine grain layer 17b, showing the portion in which the compound 18 is formed as a granular precipitate.

The semiconductor device 10 shown in Figures 1 and 2 is an IGBT module, which is a kind of power semiconductor. This semiconductor device 10 is mounted on a hybrid car and the like and is used in the control of electric power.

The semiconductor device 10 is provided with a copper plate (a Cu plate) 11 which functions as a heat sink, a ceramics substrate 19 arranged on this copper plate 11, an enclosure 12 made of resin and the like. In the interior of the enclosure 12, there are arranged a plurality of circuit layers 13, a pluralityofsiliconchips (Sichips) 16, a plurality of bonding wires 17 which are arranged between these plurality of silicon chips 16 or between the silicon chip 16 and the circuit layer 13. The circuit layers 13 and the silicon chips 16 function as connectedmembers to which the bonding wires 17 are connected. Incidentally, an aluminum electrode pad 16a is deposited on the silicon chip 16. The bonding wire 17 is joined to the aluminum electrode pad 16a deposited on the silicon chip 16.

The bonding wire 17 is made of an aluminum (Al) alloy. The aluminum alloy contains at least magnesium (Mg) and silicon and it is preferred that a total of contents of the magnesium and the silicon be not less than 0.03 wt% but not more than 1.0 wt%. It is more preferred that the total be not less than 0.1 wt% but not more than 0.9 wt%. It is still more preferred that the total be not less than 0.2 wt% but not more than 0.7 wt%.

The reason why it is preferred that the total content of magnesium and silicon be not less than 0.03 wt% is that if the total content of magnesium and silicon is less than this value, in the first place, it is impossible to obtain the hardness of the aluminum alloy. The reason why it is preferred that the total content of magnesium and silicon be not more than 1. 0 wt% is that if the total content of magnesium and silicon exceeds this value, the aluminum alloy becomes too hard, with the result that in connecting the bonding wire 17 to the silicon chip 16 via the aluminum electrode pad 16a, the silicon chip 16 is damaged due to the hardness of the bonding wire 17.

Thebondingwire 17 is for use in power semiconductors and has a prescribed diameter. It is preferred that the diameter of the bonding wire 17 be not less than 10 µm but not more than 500 µm. Preferably, this diameter is not less than 100 µm but not more than 500 µm.

The bonding wire 17 is of a type for use in bonding at ordinary temperature of not more than 60°C, it is preferred that the bonding wire 17 have hardness of not more than 35 Hmv (Vickers hardness) before aging treatment or during aging treatment, and the bonding wire 17 is hardened by aging treatment before or after bonding. Also, the bonding wire 17 is of a type for use in bonding at high temperatures of not less than 160°C but not more than 220°C, it is preferred that the bonding wire 17 have hardness of not more than 45 Hmv at ordinary temperature before aging treatment or during aging treatment and hardness of not more than 35 Hmv (Vickers hardness) at high temperatures, and the bonding wire 17 is hardened by aging treatment before or after bonding.

Reference numeral 15 in Figure 3(A) denotes a connection structure between the silicon chip 16 and the bonding wire 17 . In this connection structure 15, the bonding wire 17 is joined to the silicon chip 16. An ultrasonic joining technology which involves applying ultrasonic oscillations is used in joining the bonding wire 17. After joining, aging treatment whose treatment temperature is ordinary temperature to 300°C is performed. The aging treatment requires a treatment time which is such that, with the amount of increase in maximum hardness from an initial hardness to a maximum hardness due to the aging treatment as a standard, the aging treatment is performed until hardness of not less than 40% of the amount of increase in the maximum hardness is obtained. It is preferred that the aging treatment be performed for a treatment time until hardness of not less than 40% but not more than 70% of the amount of increase in the maximum hardness is obtained.

The silicon chip 16 is such that on the surface thereof there is formed an aluminum-silicon film 16a made of an aluminum material which functions as an aluminum electrode pad. The bonding wire 17 has a matrix layer 17a and a fine grain layer 17b of aluminum alloy which is formed between this matrix layer 17a and the silicon film 16a. This fine grain layer 17b is formed by the recrystallization of a strained area occurring during ultrasonic joining. A compound 18 containing magnesium and silicon is formed in the matrix layer 17a, in the fine grain layer 17b, and at an interface between the matrix layer 17a and the fine grain layer 17b. Specifically, in a prescribed range from the interface of the fine grain layer 17b (upward in Figure 3 (A)) to the aluminum-silicon film 16a there is formed the compound 18 containing magnesium and silicon. This compound 18 precipitates due to aging treatment. Incidentally, because in the range of 20 µm in the direction of the bonding wire 17 from the interface of the fine grain layer 17b to the aluminum-silicon film 16a, the compound 18 precipitates in amounts of not less than 0.5% in terms of the area ratio in a section in the direction of the interface between the fine grain layer 17b and the aluminum-silicon film 16a (in the horizontal direction in Figure 3(A)), even in the case where a crack is generated in the connection of the bonding wire 17 to the silicon chip 16, the propagation of this crack is prevented. Incidentally, for the shape of actual compounds 18, see the photographs shown in Figures 3 (B) and 3 (C). The compound 18 has different shapes depending on the area where the compound 18 is formed. That is, the compound 18 is sometimes formed as a rod-like precipitate as shown in Figure 3 (B) and is sometimes formed as a granular precipitate as shown in Figure 3 (C). Incidentally, Figures 3 (B) and 3 (C) show the case where a bonding wire 17 made of an aluminum alloy containing 0.5 wt% of magnesium silicide (Mg₂Si) was subjected to solution treatment at 400°C for 1 hour and then to aging hardening treatment at 200°C for 4 hours.

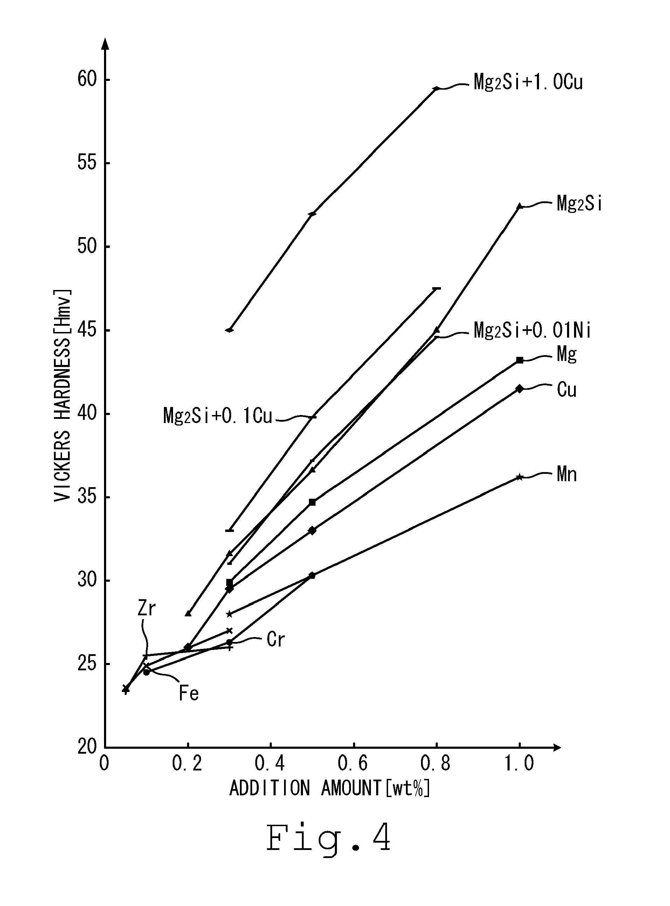

[Experiment 1] Next, Experiment 1 to investigate the hardness of various kinds of aluminum alloys will be described with the aid of Figure 4, the addition amount [wt%] on the abscissa and the hardness [Hmv] of the various kinds of aluminum alloys on the ordinate. Incidentally, the hardness of the various kinds of aluminum alloys was investigated by a Vickers hardness test at room temperature. In each of experiment, room temperature is defined as temperature that is not less than 20°C but not more than 30°C.

In Experiment 1, various kinds of aluminum alloys were used as samples. The various kinds of aluminum alloys were obtained by adding, to aluminum, each of copper, magnesium, magnesium silicide, iron (Fe), manganese (Mn), chromium (Cr) and zirconium (Zr) or a mixture obtained by adding 0.01 wt% of nickel (Ni), 0.1 wt% of copper or 1 wt% of copper to magnesium silicide. Incidentally, the various kinds of aluminum alloys used were used immediately after casting and were not subjected to aging treatment.

Incidentally, for aluminum alloys containing copper, the investigation was conducted in each of the cases where the addition amount of copper is 0.2 wt%, 0.3 wt%, 0.5 wt% and 1.0 wt%. For aluminum alloys containing magnesium silicide, the investigation was conducted in each of the cases where the addition amount of magnesium silicide is 0.2 wt%, 0.3 wt%, 0.5 wt%, 0.8 wt% and 1.0 wt%. For each aluminum alloy containing magnesium or manganese, the investigation was conducted in each of the cases where the magnesium or manganese contents are 0.3 wt%, 0.5 wt% and 1.0 wt%. For aluminum alloys containing iron or zirconium, the investigation was conducted in each of the cases where the addition amounts of iron or zirconium are 0.05 wt%, 0.1 wt% and 0.3 wt%. For aluminum alloys containing chromium, the investigation was conducted in each of the cases where the chromium content is 0.1 wt%, 0.3 wt% and 0.5 wt%. For each aluminum alloy containing 0.01 wt% of nickel, 0.1 wt% of copper or 1 wt% of copper added to magnesium silicide, the investigation was conducted in each of the cases where the addition amount of magnesium silicide to which 0.01 wt% of nickel is added, of magnesium silicide to which 0.1 wt% of copper is added, and of magnesium silicide to which 1 wt% of copper is added is 0.3 wt%, 0.5 wt% and 0.8 wt%.

Incidentally, conventional bonding wires consist of aluminum alloys containing copper. Therefore, in Experiment 1, a judgment was made in relation to aluminum alloys containing copper.

As shown in Figure 4, in the cases where the addition amount is 0.2 wt%, 0.3 wt% and 0.5 wt%, the aluminum alloys containing magnesium silicide have higher hardness than the aluminum alloys containing copper and were regarded as good in the evaluation. On the other hand, in the case where the addition amount is 1.0 wt%, the aluminum alloy containing magnesium silicide has hardness on the order of 1.25 times the hardness of the aluminum alloys containing copper and were regarded as good in the evaluation.

At all of the addition amounts of magnesium silicide, the aluminum alloys containing magnesium silicide to which 0.01 wt% of nickel is added, magnesium silicide to which 0.1 wt% of copper is added, and magnesium silicide to which 1 wt% of copper is added, have higher hardness than the aluminum alloys containing copper and were regarded as good in the evaluation.

At all of the addition amounts, the aluminum alloys containing magnesium have hardness equal to the hardness of the aluminum alloys containing copper and were regarded as good in the evaluation.

At all of the addition amounts, the aluminum alloys containing iron, manganese, chromium or zirconium have lower hardness than the aluminum alloys containing copper and were regarded as bad in the evaluation.

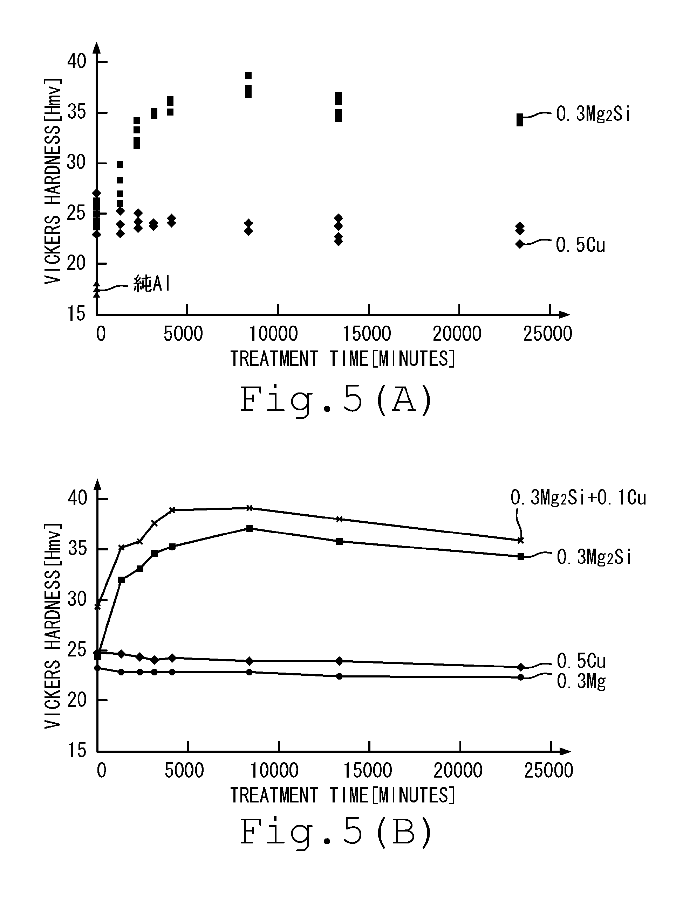

[Experiment 2] Next, in Experiment 2 the transition of hardness by aging treatment was investigated for pure aluminum and various kinds of aluminum alloys, and this experiment will be described with the aid of Figures 5(A) and 5 (B). Figures 5 (A) and 5 (B) are each graphs showing the transition of hardness by aging treatment, with treatment time [minutes] on the abscissa and hardness [Hmv] on the ordinate. Incidentally, the hardness of pure aluminum and various kinds of aluminum alloys was investigated by a Vickers hardness test at room temperature. The treatment temperature was 180°C.

For an aluminum alloy containing 0.3 wt% of magnesium silicide, an aluminum alloy containing 0.5 wt% of copper, an aluminum alloy containing 0.3 wt% of magnesium and "an aluminum alloy containing 0.3 wt% of magnesium silicide and 0.1 wt% of copper", the investigation was conducted several times in each of the cases where the treatment time is 0 minutes, 1000 minutes, 2000 minutes, 3000 minutes, 4000 minutes, 9000 minutes, 14000 minutes and 23000 minutes. For pure aluminum, the investigation was conducted several times in the case where the treatment time is 0 minutes. Incidentally, for the aluminum alloy containing 0.3 wt% of magnesium silicide and the aluminum alloy containing 0.5 wt% of copper, Figure 5 (A) shows data individually. Figure 5 (B) shows the averages obtained by investigating various kinds of aluminum alloys four times.

As shown in Figures 5 (A) and 5 (B), the hardness of the various kinds of aluminum alloys showed larger values than the pure aluminum alloys. The hardness of the aluminum alloy containing 0.5 wt% of copper and of the aluminum alloy containing 0.3 wt% of magnesium was substantially constant regardless of the transition of time.

The hardness of the aluminum alloy containing 0.3 wt% of magnesium silicide continued to increase until 9000 minutes and decreased gradually from 9000 minutes. That is, in the aluminum alloy containing 0.3 wt% of magnesium silicide, aging hardening was observed in the period until 9000 minutes.

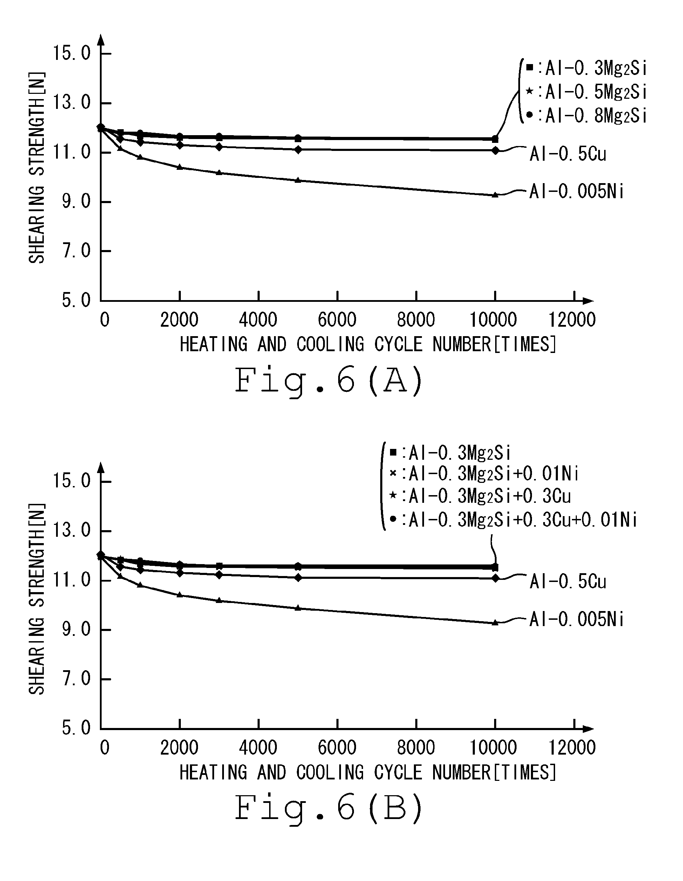

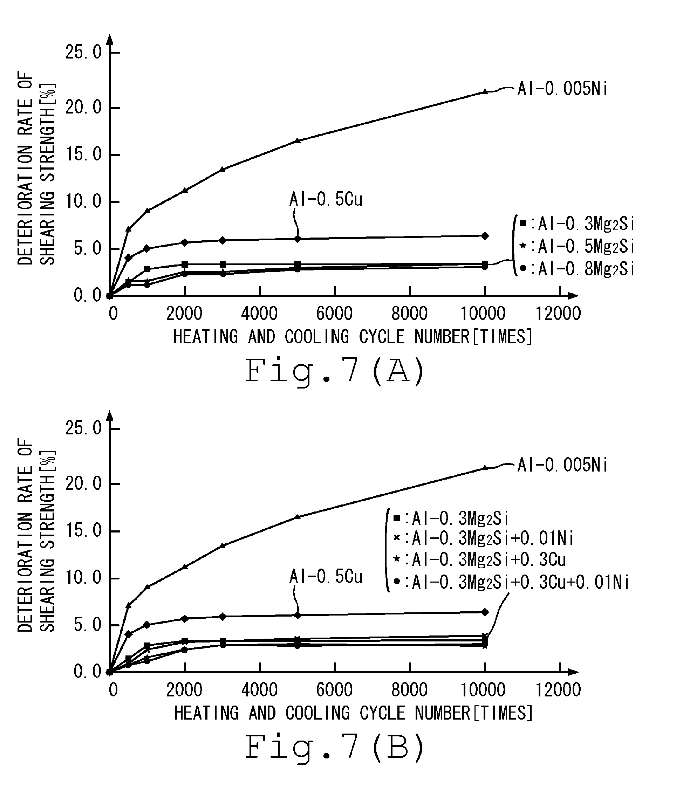

[Experiment 3] Next, Experiment 3 conducted to investigate the sharing strength of various kinds of aluminum alloys will be described with the aid of Figures 6 (A), 6 (B) and Figures 7 (A), 7 (B). Figures 6 (A) and 6 (B) are graphs showing the shear strength in the connection structure 15, with the heating and cooling cycle number [times] on the abscissa and shearing strength [N] on the ordinate. Shearing strength refers to a maximum shearing force under which the material constituting the connection structure 15 can withstand without a break. Figures 7 (A) and 7 (B) are graphs showing the deterioration rate of shearing strength in the connection structure 15, with the heating and cooling cycle number [times] on the abscissa and the deterioration rate of shearing strength [%] on the ordinate. The deterioration rate of shearing strength refers to a value which indicates by percentage the degree of deterioration based on the case where the heating and cooling cycle number is 0 times. Incidentally, in Figures 6 (A), 6 (B) and Figures 7 (A), 7 (B), each plot shown in the graphs is an average value obtained by conducting the experiment 16 times. The sharing strength of various kinds of aluminum alloys was investigated at room temperature.

In Experiment 3, repetitions of heat generation and cooling by the use of the semiconductor device 10 were created in a simulated manner. One heating and cooling cycle has a heating step for heating from 70°C to 120°C in 100 seconds and a cooling step for cooling from 120°C to 70°C in 70 seconds immediately thereafter. Each heating and cooling cycle was repeated without an interval.

For an aluminum alloy containing 0.005 wt% of nickel, an aluminum alloy containing 0.5 wt% of copper, an aluminum alloy containing 0.3 wt% of magnesium silicide, an aluminum alloy containing 0.5 wt% of magnesium silicide, an aluminum alloy containing 0.8 wt% of magnesium silicide, an aluminum alloy containing 0.3 wt% of magnesium silicide and 0.3 wt% of copper, an aluminum alloy containing 0.3 wt% of magnesium silicide and 0.01 wt% of nickel, and an aluminum alloy containing 0.3 wt% of magnesium silicide, 0.3 wt% of copper and 0.01 wt% of nickel, the investigation was conducted in each of the cases where the heating and cooling cycle number is 0 times, 500 times, 1000 times, 2000 times, 3000 times, 5000 times, and 10000 times. Incidentally, each aluminum alloy was subjected to aging treatment beforehand.

As shown in Figures 6(A), 6(B) and Figures 7(A), 7(B), in each of the aluminum alloy containing 0.3 wt% of magnesium silicide, the aluminum alloy containing 0.5 wt% of magnesium silicide, the aluminum alloy containing 0.8 wt% of magnesium silicide, the aluminum alloy containing 0.3 wt% of magnesium silicide and 0.3 wt% of copper, the aluminum alloy containing 0.3 wt% of magnesium silicide and 0.01 wt% of nickel, and the aluminum alloy containing 0.3 wt% of magnesium silicide, 0.3 wt% of copper and 0.01 wt% of nickel, the deterioration by the heating and cooling cycle became approximately 1/10 of the deterioration of the aluminum alloy containing 0.005 wt% of nickel and became approximately 1/2 of the deterioration of the aluminum alloy containing 0.5 wt% of copper.

For the deterioration in the initial period of the heating and cooling cycle, an increase in the degree of deterioration due to the progress of the heating and cooling cycle was small in each of the aluminum alloy containing 0.3 wt% of magnesium silicide, the aluminum alloy containing 0.5 wt% of magnesium silicide, the aluminum alloy containing 0.8 wt% of magnesium silicide, the aluminum alloy containing 0.3 wt% of magnesium silicide and 0.3 wt% of copper, the aluminum alloy containing 0.3 wt% of magnesium silicide and 0.01 wt% of nickel, and the aluminum alloy containing 0.3 wt% of magnesium silicide, 0.3 wt% of copper and 0.01 wt% of nickel, compared to the aluminum alloy containing 0.005 wt% of nickel and the aluminum alloy containing 0.5 wt% of copper.

In the aluminum alloy containing 0.005 wt% of nickel, the shearing strength decreased with increasing heating and cooling cycle number, that is, the deterioration rate of shearing strength increased.

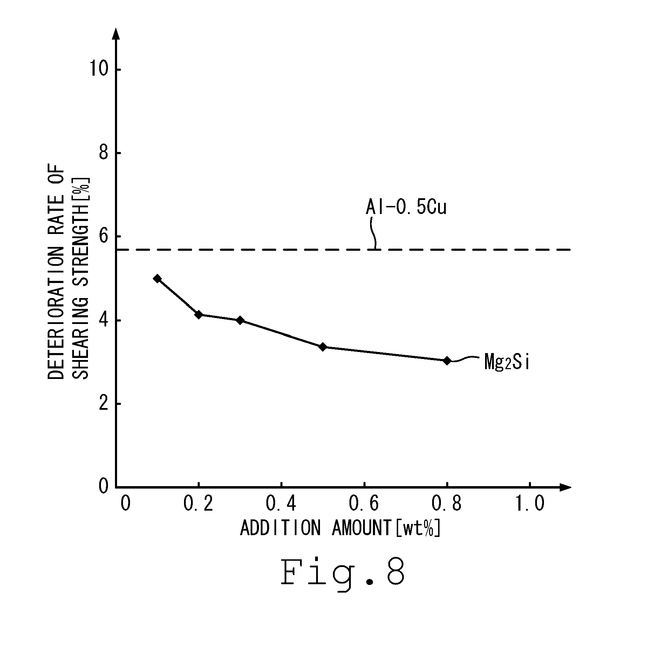

[Experiment 4] Next, Experiment 4 conducted to investigate the shearing strength of various kinds of aluminum alloys will be described with the aid of Figure 8. Figure 8 is a graph showing the deterioration rate of shearing strength in the connection structure 15, with the addition amount [wt%] of magnesium silicide on the abscissa and the deterioration rate of shearing strength [%] on the ordinate.

The data obtained in Experiment 3 is used as the data necessary for Experiment 4. That is, repetitions of heat generation and heat dissipation due to the use of the semiconductor device 10 were created in a simulated manner. One heating and cooling cycle has a heating step for heating from 70°C to 120°C in 100 seconds and a cooling step for cooling from 120°C to 70°C in 70 seconds immediately thereafter. Each heating and cooling cycle was repeated 10000 times without an interval. The sharing strength of various kinds of aluminum alloys was investigated at room temperature.

The investigation was conducted in each of the cases where the addition amount of magnesium silicide is 0.1 wt%, 0.2 wt%, 0.3 wt%, 0.5 wt% and 0.8 wt%. Incidentally, because conventional bonding wires consist of an aluminum alloy containing copper, a comparison was made with the deterioration rate of the aluminum alloy containing 0.5 wt% of copper.

At all of the contents, the aluminum alloys containing magnesium silicide have lower deterioration rates than the aluminum alloy containing copper and were regarded as good in the evaluation.

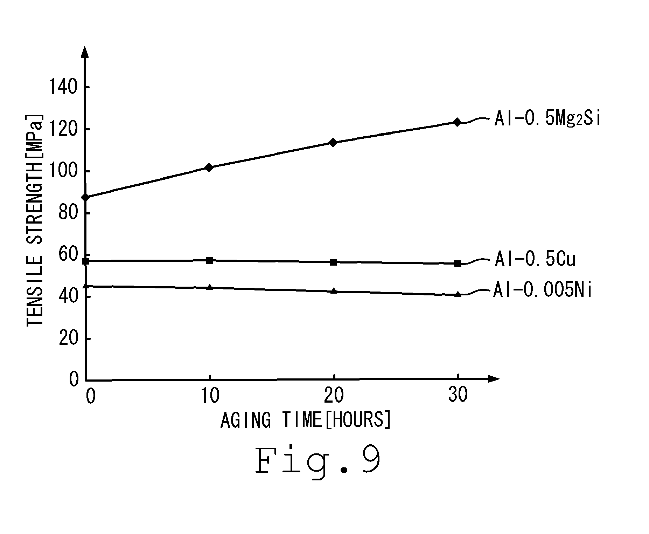

[Experiment 5] Next, Experiment 5 conducted to investigate the transition of tensile strength by aging treatment for various kinds of aluminum alloys will be described with the aid of Figure 9. Figure 9 is a graph showing the transition of tensile strength by aging treatment, with treatment time [hours] on the abscissa and tensile strength [MPa] on the ordinate. Incidentally, the investigation was conducted at a strain rate of 2 %/minute at room temperature. A bonding wire having a diameter of 0.3 mm and a length of 50 mm was used as the test piece.

For an aluminum alloy containing 0.5 wt% of magnesium silicide, an aluminum alloy containing 0.5 wt% of copper and an aluminum alloy containing 0.005 wt% of nickel, the investigation was conducted in each of the cases where the treatment time is 0 hour, 10 hours, 20 hours and 30 hours.

As shown in Figure 9, the tensile strength of the aluminum alloy containing magnesium silicide showed large values regardless of the aging time compared to the aluminum alloy containing copper or nickel. Furthermore, the tensile strength of the aluminum alloy containing magnesium silicide increased with increasing aging time.

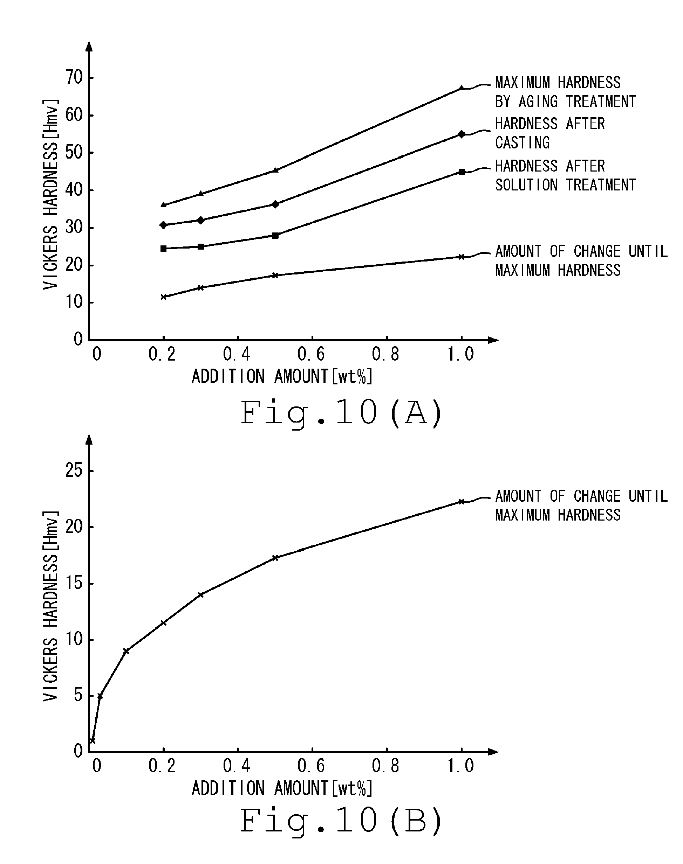

[Experiment 6] Next, Experiment 6 conducted to investigate a change in hardness for aluminum alloys containing magnesium silicide will be described with the aid of Figures 10 (A) and 10 (B). Figures 10 (A) and 10 (B) are each graphs showing the hardness of an aluminum alloy, with the addition amount [wt%] on the abscissa and the hardness [Hmv] of the aluminum alloy on the ordinate. The hardness of the aluminum alloys was investigated by a Vickers hardness test at room temperature.

For each of the hardness after casting, the hardness after solution treatment (hardness before aging treatment, initial hardness by aging treatment) and the maximum hardness by aging treatment, the investigation was conducted in each of the cases where the addition amount of magnesium silicide is 0.2 wt%, 0.3 wt%, 0.5 wt% and 1.0 wt%. For an amount of change in hardness until a maximum hardness by aging treatment (= "maximum hardness by aging treatment" - "hardness after solution treatment"), the investigation was conducted in each of the cases where the addition amount is 0.01 wt%, 0.03 wt%, 0.1 wt%, 0.2 wt%, 0.3 wt%, 0.5 wt% and 1.0 wt%. Incidentally, an amount of change in hardness until a maximum hardness by aging treatment equals "maximum hardness by aging treatment" minus "hardness after solution treatment".

As shown in Figure 10 (B), a change in hardness until a maximum hardness by aging treatment increased with increasing addition amount of magnesium silicide (as if a logarithm function were drawn in the graph of Figure 10 (B)).

As described above, according to the semiconductor device 10, the generation of cracks in the bonding wire 17 is prevented by the solid-solution hardening by the magnesium and silicon contained in the bonding wire 17. Furthermore, even in the case where a crack is generated in a connection of the bonding wire 17 to the silicon chip 16, the propagation of the crack is prevented by the precipitation hardening of the compound 18 which precipitates at an interface between the fine grain layer 17b and the aluminum-silicon film 16a.

Furthermore, because the hardness of the bonding wire 17 has not reached a maximum hardness, in connecting the bonding wire 17 to the silicon chip 16, the silicon chip 16 is prevented from being damaged due to the hardness of the bonding wire 17. During the use of the semiconductor device 10, the aging hardening of the bonding wire 17 due to heat generation proceeds further. As a result of this, an improvement in the operation life of the connection structure 15 is further achieved.

The present invention is not limited to the above-described embodiment, and various kinds of variations are possible so long as such variations do not depart from the gist and technical philosophy of the invention.

That is, in the above-described embodiment, the bonding wire 17 may contain not less than 0.001 wt% but not more than 0.01 wt% of nickel or not less than 0.1 wt% but not more than 1.0 wt% of copper. When nickel is added, humidity resistance is improved. When copper is added, hardness is further improved.

Alternatively, although in the above-described embodiment, with the amount of increase in maximum hardness from an initial hardness to a maximum hardness due to aging treatment as a standard, aging treatment is performed for treatment time until hardness of not less than 40% of the amount of increase in the maximum hardness is obtained, a wire before joining may sometimes be subjected to aging hardening until a maximum hardness. Also, there is the case where aging treatment is not performed before joining and aging hardening proceeds at a working temperature after joining.

Alternatively, in the above-described embodiment, as the semiconductor device 10, a general power module, a power MOS transistor, a diode module and the like may be used in place of the IGBT module.
The generation and propagation of cracks in a connection to a connected member is prevented. A semiconductor device 10 is provided with a connection structure 15 between a bonding wire 17 consisting of an aluminum alloy which contains at least magnesium and silicon and in which a total of contents of the magnesium and the silicon is not less than 0.03 wt% but not more than 1.0 wt% and a silicon chip 16 to which this bonding wire 17 is connected. An aluminum-silicon film 16a is formed on the surface of the silicon chip 16. This connection structure 15 has a compound 18 containingmagnesium and silicon in a matrix layer 17a constituting the bonding wire 17, in a fine grain layer 17b of the aluminum alloy formed between the matrix layer 17a and the aluminum-silicon film 16a, and at an interface between the matrix layer 17a and the fine grain layer 17b.

## Claims

1. Abonding wire **characterized in** consisting of an aluminum alloy which contains at least magnesium and silicon and **in that** a total of contents of the magnesium and the silicon is not less than 0.03 wt% but not more than 1.0 wt%.

2. The bonding wire according to claim 1 **characterized in** having a diameter of not less than 10 µm but not more than 500 µm.

3. The bonding wire according to claim 1 or 2 **characterized in that** with the amount of increase in maximum hardness from an initial hardness to amaximumhardness due to aging treatment as a standard, aging treatment is performed until an increase in hardness of not less than 40% of the amount of increase in the maximum hardness is obtained.

4. The bonding wire according to any of claims 1 to 3 **characterized in that** the hardness becomes not more than 45 Hmv.

5. The bonding wire according to claim 4 **characterized in that** the hardness becomes not more than 35 Hmv.

6. The bonding wire according to any of claims 1 to 5 **characterized in that** the aluminum alloy contains not less than 0.1 wt% but not more than 1.0 wt% of copper.

7. The bonding wire according to any of claims 1 to 6 **characterized in that** the aluminum alloy contains not less than 0.001 wt% but not more than 0.01 wt% of nickel.

8. A connection structure **characterized in** being a connection structure between the bonding wire according to any of claims 1 to 7 and a connected member to which the bonding wire is connected and which consists of an aluminum material, and **in that** a compound containing magnesium and silicon precipitates in a matrix layer constituting the bonding wire, in a fine grain layer of the aluminum alloy formed between the matrix layer and the connected member, and at an interface between the matrix layer and the fine grain layer.

9. The connection structure according to claim 8 **characterized in that** the compound contains aluminum.

10. The connection structure according to claim 8 or 9 **characterized in that** the amount of precipitation of the compound is not less than 0.5% in terms of the area ratio of a section in the direction of the interface.

11. A semiconductor device **characterized in** having the connection structure according to any of claims 8 to 10.

12. A method of manufacturing the semiconductor device according to claim 11 **characterized in that** after the bonding wire is connected to the connected member, the bonding wire is subjected to aging treatment.
